**Europäisches Patentamt**

**European Patent Office**

**Office européen des brevets**

(19)

(11) Veröffentlichungsnummer : **0 012 319**
**B2**

(12) NEUE EUROPÄISCHE PATENTSCHRIFT

(45) Veröffentlichungstag der neuen Patentschrift :
02.01.86

(21) Anmeldenummer : **79104855.6**

(22) Anmeldetag : **03.12.79**

(51) Int. Cl.⁴ : **B 23 K 1/08**, B 23 K 3/00,
H 05 K 3/34

(54) **Verfahren und Schablone zum Befestigen von Bauelementen mit flächigen Anschlusskontakten auf Leiterplatten.**

(30) Priorität : **06.12.78 DE 2852753**

(43) Veröffentlichungstag der Anmeldung :
**25.06.80 Patentblatt 80/13**

(45) Bekanntmachung des Hinweises auf die Patenterteilung : **21.10.81 Patentblatt 81/42**

(45) Bekanntmachung des Hinweises auf die Entscheidung
über den Einspruch : **02.01.86 Patentblatt 86/01**

(84) Benannte Vertragsstaaten :
**AT BE CH FR GB IT LU NL SE**

(56) Entgegenhaltungen :
**DE-A- 2 640 613**
**DE-B- 1 065 898**
**DE-B- 1 089 437**
**DE-B- 1 194 681**
**DE-B- 2 633 269**
**FR-A- 1 484 521**
**GB-A- 1 036 222**
**US-A- 3 355 078**
**US-A- 3 516 155**
**US-A- 3 588 425**
**US-A- 3 991 347**
**Bauteile Report 17 (1978) Heft 2 S. 40-44**
**Siemens Datenbuch 1978/79 S. 22,23, 288-297, 31, 319**

(73) Patentinhaber : **WÜRTTEMBERGISCHE METALLWA-
RENFABRIK AG.**
**Postfach 76**
**D-7340 Geislingen/Steige (DE)**

(72) Erfinder : **Motsch, Hans**
**Südmährerstrasse 40**
**D-7340 Geislingen/Steige (DE)**

(74) Vertreter : **Patentanwälte Dipl.-Ing. A. Grünecker,
Dr.-Ing. H. Kinkeldey, Dr.-Ing. W. Stockmair,
Dr. rer. nat. K. Schumann, Dipl.-Ing. P.H. Jakob, Dr.
rer. nat. G. Bezold Maximilianstrasse 58
D-8000 München 22 (DE)**

**Beschreibung**

Die vorliegende Erfindung bezieht sich auf ein Verfahren zum Befestigen von flachen, filmartigen Bauelementen mit flächigen, mit Lotschichten versehenen Anschlußkontakten auf Leiterplatten, bei dem die Anschlußkontake mit Lotschichten der Leiterplatte mittels geführter Andrückelemente und durch Zufuhr der zum Verschmelzen der Lotschichten erforderlichen Wärme von der den Bauelementen gegenüberliegenden Seite der Leiterplatte her verlötet werden.

Bei einem aus der DE-OS 26 40 613 bekannten Verfahren dieser Art werden die filmartigen Bauelemente (Mikropacks) einzeln auf die Leiterplatte aufgeklebt und im Bereich ihrer Anschlußkontakte mit Stiften angedrückt, die in einem mit Druckmittel beschickbaren, oberhalb der Arbeitsstelle angeordneten Zylinder geführt sind. Die Leiterplatte ruht dabei auf einem Arbeitstisch, der unterhalb des von dem Bauelement abgedeckten Bereichs eine Ausnehmung hat, durch welche mittels Infrarotstrahlung oder Gasflamme Wärme auf die Unterseite der durchgehenden Leiterplatte aufgebracht wird. Die durch die Leiterplatte fließende Wärme bringt die Lotschichten zum Aufschmelzen. Nachteilig an diesem Verfahren ist zunächst, daß eine äußerst genaue Wärmesteuerung erforderlich ist, um einerseits durch die Leiterplatte hindurch genügend Wärme zu den Kontaktstellen zu bringen, um die Lotschichten zuverlässig aufzuschmelzen, andererseits jedoch eine Beschädigung der wärmeempfindlichen Bauelemente zu vermeiden. Wegen dieser Schwierigkeiten arbeitet das bekannte Verfahren nicht zuverlässig. Da die Wärme durch die Leiterplatte, die normalerweise ein schlechter Wärmeleiter ist, hindurchfließen muß, ist das bekannte Verfahren auch zeit- und arbeitsaufwendig. Dieser Nachteil wird noch dadurch gesteigert, daß die Bauelemente einzeln auf die Leiterplatte aufgebracht und dort verklebt werden müssen.

Bei einem anderen bekannten Verfahren werden die flächigen Bauelemente unter Zuhilfenahme eines Lötrahmens auf der Leiterplatte verlötet. Hierzu werden die Elemente einzeln mit einer Saugpinzette in der erforderlichen Stellung auf der Leiterplatte aufgesetzt, und die Kontaktstellen werden mittels des Lötrahmens verlötet. Hierbei wird mittels des Lötrahmens die Wärme von oben durch die Elemente hindurch zu den Anschlußstellen gebracht. Dieses Verfahren ist selbst bei maschineller Fertigung zeitintensiv, da die einzelnen Bauelemente nacheinander aufgesetzt und verlötet werden müssen. Außerdem besteht die Gefahr einer Wärmeschädigung der Bauelemente.

Schließlich ist es bekannt, mittels einer Wärmeplatte oder Strahlern die Temperatur auf der Oberfläche einer Leiterplatte so zu steuern, daß an den gewünschten Verbindungsstellen von Leiterbahnen auf der Leiterplatte und den flächigen Anschlußkontakten der Bauelemente die Löttemperatur erreicht wird. Auch hier ist eine genaue Wärmesteuerung sehr schwierig, so daß das Verfahren nicht zuverlässig arbeitet. Es ist außerdem zeitaufwendig.

Der Erfindung liegt die Aufgabe zugrunde, ein Verfahren der eingangs genannten Art anzugeben, das zuverlässiger und weniger arbeitsintensiv ist als die bekannten Verfahren.

Diese Aufgabe wird erfindungsgemäß dadurch gelöst, daß eine Vielzahl von flächigen Bauelementen vor dem Lötvorgang mittels einer Schablone an die Leiterplatte angelegt wird, daß die Andrückelemente in der Schablone geführt sind, und daß die Wärme über im Bereich der Anschlußkontakte in der Leiterplatte vorgesehene, durchkontaktierte Löcher durch flüssiges Lot zugeführt wird.

Bei dem erfindungsgemäßen Verfahren wird eine Vielzahl von Bauelementen in einem Arbeitsvorgang auf der Leiterplatte befestigt. Die hierdurch erzielte Zeitersparnis ist beträchtlich. Ein besonderer maschineller Aufwand ist nicht erforderlich. Ganz besonders günstig an dem erfindungsgemäßen Verfahren ist jedoch, daß die Wärme mittels des flüssigen Lotes sehr rasch und durch die durchkontaktierten Löcher sehr genau an die gewünschten Stellen gebracht wird. Dadurch kann das Verfahren in kürzester Zeit durchgeführt werden und es läßt sich ohne weiteres sicherstellen, daß nicht zu viel Wärme an die Bauelemente selbst gelangt. Auf diese Weise werden sämtliche Anschlußkontakte zuverlässig verlötet, ohne die Gefahr einer Beschädigung der Bauelemente selbst.

Besonders vorteilhaft wird das Verfahren dann, wenn gleichzeitig flache, filmartige Bauelemente und mit durch Löcher in der Leiterplatte ragenden Anschlußstiften versehene Bauelemente verlötet werden. Es ist dann nur ein einziger Lötvorgang notwendig, um die beiden Arten von Bauelementen mit der Leiterplatte zu verlöten.

Es ist zwar aus der US-PS 3 991 347 bekannt, elektronische Filter mit einem zylindrischen Gehäuse und von diesem vorstehenden Anschlußstiften dadurch mit einer Leiterplatte zu verlöten, daß die Stifte in durchkontaktierte Löcher der Leiterplatte eingesteckt und der Mantel des zylindrischen Filtergehäuses auf die freien Enden ebenfalls durchkontaktierter Löcher in der Platte aufgelegt und dann in einem Lötbad die Stifte und der Mantel zugleich angelötet werden. Hierbei handelt es sich jedoch nicht um filmartige Bauelemente ; außerdem sind im Bereich des Filtermantels keine Lotschichten vorhanden, die mittels des flüssigen Lotes aufgeschmolzen werden. Vielmehr dient hier das flüssige Lot ausschließlich selbst dazu, die Verbindung zwischen dem Filtergehäuse und der Leiterplatte herzustellen.

Bekannt ist es ferner aus der DE-AS 26 33 269 elektronische Bauelemente mit flachen Anschlußkontakten auf einer Leiterplatte dadurch zu befestigen, daß die Leiterplatte auf ein flüssiges Zinnbad aufgesetzt wird. Die Wärme muß hier wiederum durch die Leiterplatte hindurchströmen, wodurch die Zuverlässigkeit des Verfahrens beeinträchtigt wird. Es läßt sich auf diese Weise nämlich die Wärme kaum auf die Kontaktstellen beschränken, so daß entweder mangelhafte Kontakte hergestellt oder die elektronischen Bauelemente beschädigt werden.

Schließlich ist es beim Zusammenbau elektrischer Komponenten im Prinzip auch aus der US-PS 3 355 078 bekannt, mit einer Schablone zu arbeiten.

Im folgenden wird ein Ausführungsbeispiel der Erfindung anhand der Zeichnung näher erläutert. Es zeigen :

Figur 1 eine Draufsicht auf einen Ausschnitt einer Leiterplatte mit einem darauf zu befestigenden Bauelement,

Figur 2 einen Querschnitt der Anordnung gemäß Fig. 1 entlang der Linie II-II, die linke Kontaktstelle unverlötet, die rechte Kontaktstelle verlötet,

Figur 3 eine Ansicht von unten einer Schablone, die zum Andrücken eines Bauelementes an die Oberfläche einer Leiterplatte dient, und

Figur 4 einen Querschnitt entlang der Linie IV-IV in Fig. 3.

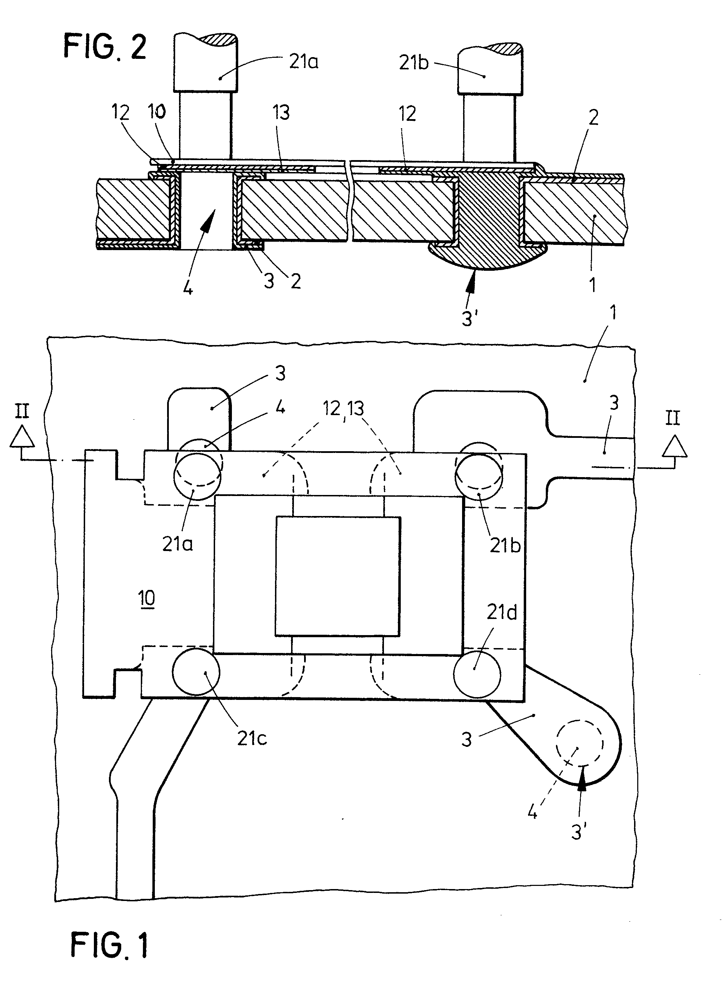

Fig. 1 zeigt einen Ausschnitt einer Leiterplatte 1. Die Leiterplatte 1 ist mit mehreren durch eine Kupferschicht 2 und eine Zinnschicht 3 durchkontaktierten Löchern 4 versehen. Die Kupferschicht 2 und die Zinnschicht 3 erstrecken sich teilweise auf den Oberflächen der Leiterplatte 1.

Auf die Leiterplatte 1 ist ein einen Hall-Generator enthaltendes Hall-IC positioniert, welches von einem aus Kapton bestehenden Bauelement 10 in Gestalt eines Filmplättchens gehalten wird. Wie aus Fig. 2 hervorgeht, besitzt das Bauelement 10 mehrere flächige Anschlußkontakte 12, 13, jeweils bestehend aus einer Kupfer (Cu)-schicht (12) und einer Blei-Zinn (PbSn)-schicht (13).

Um das Bauelement 10 auf der Leiterplatte 1 zu befestigen, werden zuerst die Löcher 4 mit der Durchkontaktierung hergestellt. Dieser Vorgang geschieht zweckmäßigerweise gleichzeitig mit dem Bohren und Durchkontaktieren für die anderen Bauelemente, die auf der Leiterplatte 1 zu befestigen sind und die mit Anschlußstiften versehen sind, welche in die Löcher gesteckt werden, so daß sie auf der gegenüberliegenden Seite der Leiterplatte aus den Löchern herausragen. Sodann werden die Bauelemente 10 auf der Leiterplatte 1 positioniert. Dies geschieht mittels einer noch unten zu erläuternden Schablone, in oder auf die die Bauelemente 10 mit den Anschlußkontakten nach oben gelegt werden. Die Schablone wird dann auf der Leiterplatte, beispielsweise durch Verschrauben, befestigt, so daß die Bauelemente 10 mit den Anschlußkontakten 12, 13 richtig positioniert sind. Wie man bereits aus den Figuren 1 und 2 ersehen kann, besitzt die Schablone Gewichte 21a bis 21d, die auf das Filmplättchen an den Stellen der Anschlußkontakte drücken, damit die Anschlußkontakte flach auf der Leiterplattenoberfläche aufliegen.

Dieser Zustand ist in Fig. 2 auf der linken Seite veranschaulicht.

In einem weiteren Arbeitsvorgang wird die Leiterplatte mit der Unterseite durch ein Lötbad gezogen, so daß das flüssige Lot in dem Loch 4 aufsteigt und mit der Zinnschicht der Durchkontaktierung und der Blei-Zinn-Schicht des Bauelementes 10 verschmilzt. Hierdurch ergibt sich eine Lötstelle, die schematisch auf der rechten Seite in Fig. 2 dargestellt ist und mit dem Bezugszeichen 3' bezeichnet ist. Bei dem letzten Arbeitsvorgang sind auch die übrigen, mit Anschlußstiften versehenen Bauelemente auf der Leiterplatte verlötet worden.

Wie man in Fig. 1 rechts unten sieht, braucht der Anschlußkontakt des Bauelementes 10 nicht direkt über dem entsprechenden Loch in der Leiterplatte 4 positioniert zu sein, sondern es kann ein Abstand vorhanden sein. Auch in dieser Stellung erwärmt das in der Bohrung 4 aufsteigende Lot die Zinnschicht auf der Plattenoberseite so stark, daß auch hier eine gute Lötung erfolgt. Anders ausgedrückt : Für das Verlöten der Anschlußstelle ist nicht flüssiges Fremdlot erforderlich, sondern die Wärmezufuhr erfolgt durch das flüssige Lot über die Cu-Durchkontaktierung und die Leiterbahn.

Besonders günstige Lötergebnisse werden erzielt, wenn bei dem geschilderten Verfahren die Bohrungen 4 mit einem Durchmesser zwischen 0,3 und 1,6 mm ausgebildet werden.

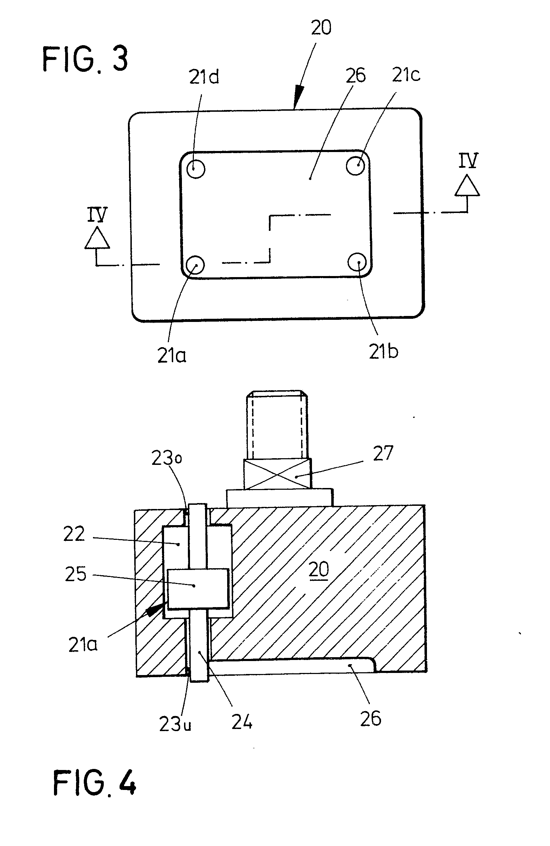

Fig. 3 zeigt von unten eine Schablone 20 zum Aufnehmen eines einzelnen flachen Bauelementes, wie beispielsweise des Bauelementes 10 in Fig. 1. In der Schablone 20 sind vier Andrückelemente 21a bis 21d verschieblich gelagert. Wie aus Fig. 4 hervorgeht, ist für jedes Andrückelement eine Kammer 22 in dem Schablonengehäuse ausgebildet. Das Andrückelement 21a besteht aus einem Stift 24 und einem Gewicht 25. Das Gewicht 25 befindet sich in der Kammer 22, und die beiden Enden des Stiftes 24 ragen nach oben und unten durch eine Öffnung 23o bzw. 23u. Die untere Öffnung 23u mündet in eine Aussparung 26. Diese Aussparung 26 dient zur Aufnahme eines Bauelements. Weiterhin besitzt die Schablone 20 ein Befestigungselement 27, welches das Aneinanderreihen mehrerer Schablonen 20 gestattet.

Zum Befestigen des Bauelementes 10 wird die Schablone so gelegt, daß die Aussparung 26 nach oben weist, und ein Bauelement 10 wird so in die Aussparung 26 eingelegt, daß die flächigen Anschlußkontakte 12, 13 nach oben, (d. h. in Fig. 4 nach unten) weisen. Dann wird die Leiterplatte 1 auf die Schablone gelegt und befestigt, beispielsweise durch Verschrauben. Wenn die Leiterplatte mit der den Bauelementen gegenüberliegenden Seite durch ein Lötbad gezogen wird, fallen die Andrückelemente 21 in den Kammern nach unten und drücken das Bauelement 10 auf die Oberfläche der Leiterplatte, und zwar greifen die Stifte 24 dort an, wo in dem Bauelement 10 die Anschlußkontakte ausgebildet sind. Man sieht, daß die Andrückkraft an allen Stellen des Bauelementes 10 etwa gleich groß ist, unabhängig von der « Höhe » des Bauelements an der betreffenden Stelle.

Es ist für den Fachmann klar, wie die Schablone, die vorzugsweise aus Kunststoff besteht, für mehrere Bauelemente auszulegen ist, so daß gleichzeitig ein ganzer Satz von Bauelementen auf die Leiterplatte aufgebracht werden kann. Obschon dies nicht in der Zeichnung dargestellt wurde, dürfte es für den Fachmann klar sein, daß die Schablone beispielsweise Bohrungen oder Stifte aufweisen kann, mittels derer die Schablone auf der Leiterplatte festgeschraubt oder geklemmt werden kann, um nach dem Lötvorgang rasch abgenommen werden zu können. Ebenso können die Andrückelemente anstelle der in Führungen verschiebbaren Gewichte als Stifte ausgebildet werden, die einzeln oder gemeinsam über Federelemente angedrückt werden.

## Patentansprüche

1. Verfahren zum Befestigen von flachen, filmartigen Bauelementen (10) mit flächigen, mit Lotschichten (13) versehenen Anschlußkontakten (12, 13) auf Leiterplatten (1), bei dem die Anschlußkontakte (12, 13) mit Lotschichten (3) der Leiterplatte (1) mittels geführter Andrückelemente (21a-d) und durch Zufuhr der zum Verschmelzen der Lotschichten (3, 13) erforderlichen Wärme von der den Bauelementen (10) gegenüberliegenden Seite der Leiterplatte (1) her verlötet werden, dadurch gekennzeichnet, daß eine Vielzahl von flächigen Bauelementen (10) vor dem Lötvorgang mittels einer Schablone (20) an die Leiterplatte (1) angelegt wird, daß die Andrückelemente (21a-d) in der Schablone (20) geführt sind, und daß die Wärme über im Bereich der Anschlußkontakte (12, 13) in der Leiterplatte (1) vorgesehene, durchkontaktierte Löcher (4) durch flüssiges Lot zugeführt wird.

2. Verfahren nach Anspruch 1, dadurch gekennzeichnet, daß der Lötvorgang mittels eines Lötbades erfolgt.

3. Verfahren nach Anspruch 1 oder 2, dadurch gekennzeichnet, daß gleichzeitig sowohl flache, filmartige Bauelemente (10) und mit durch Löcher in der Leiterplatte (1) ragenden Anschlußstiften versehene Bauelemente verlötet werden.

## Claims

1. A method for securing flat film-like structural components (10) having flat terminal contacts (12, 13) provided with solder layers (13) on printed circuit boards (1), wherein said terminal contacts (12, 13) are soldered to solder layers (3) of said printed circuit board (1) by means of guided pressure elements (21a-d) and by supplying the heat required for fusing said solder layers (3, 13) from the side of said printed circuit board (1) opposite to said structural components (10), characterized in that a plurality of said flat structural elements (10) is applied to said printed circuit board (1) prior to the soldering step by means of a jig (20), that said pressure elements (21a-d) are guided in said jig (20), and in that said heat is supplied by means of liquid solder through contact passages (4) provided in said printed circuit board (1) adjacent said terminal contacts (12, 13).

2. A method according to claim 1, characterized in that the soldering step is carried out by means of a solder bath.

3. A method according to claim 1 or 2, characterized in that both flat, film-like structural elements (10) and structural elements provided with terminal pins projecting through holes in said printed circuit board (1) are simultaneously soldered.

## Revendications

1. Procédé pour la fixation de composants (10) plats du genre film dotés de contacts de connexion (12, 13) surfaciques et de couches de soudure (13) sur des circuits imprimés (1), dans lequel les contacts de connexion (12, 13) sont soudés avec des couches de soudure (3) du circuit imprimé (1) au moyen d'éléments d'appui guidés (21a-d) et par rapport à la chaleur nécessaire à la fonte des couches de soudure (3, 13) par le côté du circuit imprimé (1) opposé à celui des composants (10), caractérisé en ce que plusieurs composants (10) surfaciques sont disposés sur le circuit imprimé (1) avant l'opération de soudage au moyen d'un gabarit (20), en ce que les éléments d'appui (21a-d) sont guidés dans le gabarit (20) et en ce que la chaleur est véhiculée par de la soudure liquide dans des trous de contact prévus dans le circuit imprimé (1) dans la zone des contacts de connexion (12, 13).

2. Procédé selon la revendication 1, caractérisé en ce que l'opération de soudage est réalisée au moyen d'un bain de soudure.

3. Procédé selon l'une des revendications 1 ou 2, caractérisé en ce que des composants (10) plats du genre film et des composants dotés de broches de connexion pénétrant dans les trous du circuit imprimé sont soudés simultanément.

FIG. 2

21a

21b

12 10

13

12

2

4

3 2

3'

1

1

3

4

12,13

3

II

II

21a

21b

10

21d

21c

3

3'

4

FIG. 1

FIG. 3

FIG. 4